# EUROPÄISCHE PATENTSCHRIFT

(11) **EP 1 486 791 B1**
(45) Veröffentlichungstag und Bekanntmachung des Hinweises auf die Patenterteilung: **30.07.2008**
(21) Anmeldenummer: 03013123.9
(22) Anmeldetag: 11.06.2003
(51) Int. Cl.: G01R 31/303, G01R 31/28, G01R 31/26

(54) **Halbleiter-Chip mit einer Überwachungseinrichtung, durch welche überwachbar ist, ob der Halbleiter-Chip mechanisch beschädigt ist**
Semiconductor chip, comprising a monitoring device, which can be used to monitor whether the semiconductor chip is mechanically damaged
Puce semi-conductrice qui présente un dispositif de surveillance qui permet de surveiller si la puce semi-conductrice a été endommagée mécaniquement

(43) Veröffentlichungstag der Anmeldung: 15.12.2004
(73) Patentinhaber: Infineon Technologies AG, 81669 München (DE)
(72) Erfinder: von Wendorff, Wilhard Christophorus, Dr., 81251 München (DE)
(74) Vertreter: Repkow, Ines

(56) Entgegenhaltungen:
- EP-A- 1 069 407
- DE-A- 19 723 080
- US-A- 6 014 091
- US-B1- 6 265 889
- PATENT ABSTRACTS OF JAPAN vol. 2000, no. 24, 11. Mai 2001 (2001-05-11) -& JP 2001 201753 A (OHT KK), 27. Juli 2001 (2001-07-27) -& WO 01 53842 A (ISHIOKA SHOGO; YAMAOKA SHUJI) 26. Juli 2001 (2001-07-26)

## Beschreibung

Die vorliegende Erfindung betrifft eine Vorrichtung gemäß dem Oberbegriff des Patentanspruchs 1, d.h. einen Halbleiter-Chip.

Halbleiter-Chips sind seit vielen Jahren in unzähligen Ausführungsformen bekannt und bedürfen keiner näheren Erläuterung.

Halbleiter-Chips werden mittlerweile in fast allen technischen Gebieten eingesetzt.

Beim Einsatz von Halbleiter-Chips in bestimmten technischen Gebieten, beispielsweise beim Einsatz von Halbleiter-Chips zur Steuerung eines Anti-Blockier-Systems oder eines Airbags eines Kraftfahrzeuges ist es von größter Bedeutung, daß die Halbleiter-Chips unter allen Umständen fehlerfrei arbeiten. Die Mindestanforderung, die hierbei erfüllt werden muß, besteht darin, daß die Halbleiter-Chips und/oder das die Halbleiter-Chips enthaltende System Fehlfunktionen selbständig erkennen und sich beim Auftreten einer Fehlfunktion in einen definierten Zustand versetzen können.

Dies wird bisher beispielsweise dadurch erreicht, daß bestimmte Systemkomponenten mehrfach vorgesehen werden und/oder sich gegenseitig überwachen. Dies, und ferner der Umstand, daß die mehrfach vorgesehenen und/oder die sich gegenseitig überwachenden Systemkomponenten zur Erzielung einer möglichst zuverlässigen Funktion auf verschiedenen Halbleiter-Chips untergebracht werden müssen, macht ein solches System groß und teuer.

Das Dokument US 6,265,889 B1 beschreibt einen Test-Schaltkreis für einen LCD Halbleiter mit zwei Bus-Leitungen und zwei Schaltkreise. Der Test-Schaltkreis umfasst zwei Treiber-Schaltkreise und zwei Schaltkreise, die elektrische Eigenschaften detektieren. Der Test-Vorgang umfasst zwei Signale aus den Schaltkreisen, die, zusammen mit einem bestimmten Ablauf der Treibersignale, nach dem Vorgang erfasst werden.

JP 2001-201753 A beschreibt ein Verfahren zum Überprüfen eines LCD-Panels, wobei Signale eingespeist und danach ausgewertet werden.

EP 1 069 407 A1 beschreibt eine Gebereinrichtung für einen Sensor, bei der mittels einer Signalerkennungseinrichtung einen Fehlerzustand aufgrund eines Leitungsbruches in den Versorgungszuleitungen erkannt wird.

US 6,014,091 beschreibt eine Vorrichtung zur Fehlerermittlung in einem Sensor, bei der Binärsignale eingespeist und später ausgewertet werden.

DE 197 23 080 A1 beschreibt ein Prüfverfahren zur Ermittlung von Defekten in Halbleiterbauelementen durch Anlegen vorbestimmter Lastimpulse und Ermitteln der Werte des thermischen Widerstandes.

Der vorliegenden Erfindung liegt daher die Aufgabe zugrunde, eine Möglichkeit zu finden, durch welche sich ein Halbleiter-Chips enthaltendes System, das unter keinen Umständen fehlerhaft arbeiten darf, mit geringerem Aufwand realisieren läßt als es bisher der Fall ist.

Diese Aufgabe wird erfindungsgemäß durch den in Patentanspruch 1 beanspruchten Halbleiter-Chip gelöst.

Der erfindungsgemäße Halbleiter-Chip zeichnet sich dadurch aus, daß er eine Überwachungseinrichtung enthält, durch welche überwacht wird, ob der Halbleiter-Chip mechanisch beschädigt ist.

Dies ermöglicht es, daß der Halbleiter-Chip mechanische Beschädigungen wie beispielsweise einen Bruch des Halbleiter-Chips und/oder einen Riß im Halbleiter-Chip und/oder eine übermäßige Verformung des Halbleiter-Chips selbst erkennt und auf eine geeignete Art und Weise darauf reagiert.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: einen Halbleiter-Chip mit einer Überwachungseinrichtung, durch welche überwacht wird, ob der Halbleiter-Chip mechanisch beschädigt ist,
- Figur 2: eine vorteilhafte Weiterbildung einer Testsignal-Leitung der in der Figur 1 gezeigten Überwachungseinrichtung, und
- Figur 3: eine weitere vorteilhafte Weiterbildung der Testsignal-Leitung.

Bei dem im folgenden beschriebenen Halbleiter-Chip handelt es sich um eine programmgesteuerte Einheit wie beispielsweise einen Mikroprozessor, einen Mikrocontroller, oder einen Signalprozessor. Die im folgenden beschriebenen Besonderheiten des Halbleiter-Chips können aber auch bei beliebigen anderen Halbleiter-Chips wie beispielsweise Speicher-Chips, Logik-Bausteinen, Power-Bausteinen etc. zum Einsatz kommen.

Von dem im folgenden beschriebenen Halbleiter-Chip sind in den Figuren nur die Überwachungseinrichtung, durch welche überwacht wird, ob der Halbleiter-Chip mechanisch beschädigt ist, sowie die Komponenten des Halbleiter-Chips gezeigt, die im betrachteten Beispiel durch die Überwachungseinrichtung gesteuert werden. Der Halbleiter-Chip enthält darüber hinaus diverse weitere, in den Figuren nicht gezeigte Komponenten. Zu diesen Komponenten gehören im betrachteten Beispiel eine oder mehrere CPUs, eine oder mehrere Speichereinrichtungen, und diverse Peripherieeinheiten, wie beispielsweise A/D-Wandler, D/A-Wandler, Timer, DMA-Controller, CAN-Controller etc.

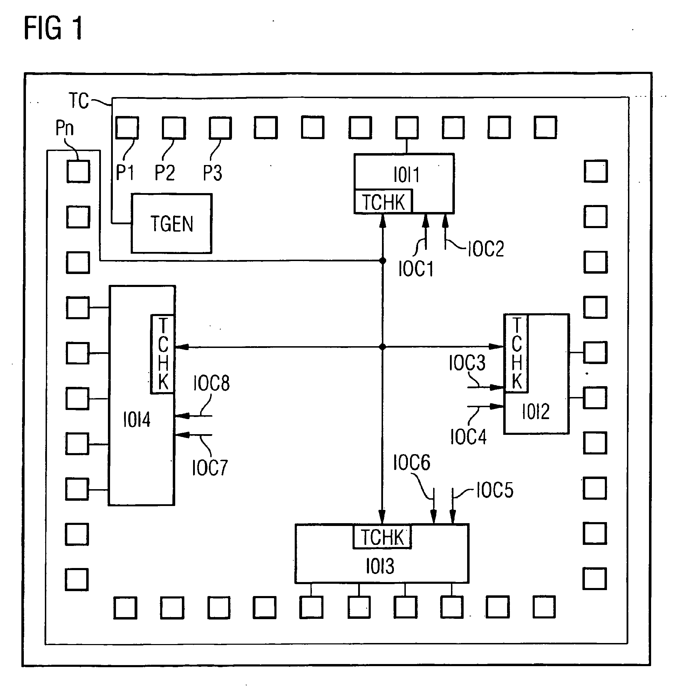

Der in Figur 1 gezeigte Halbleiter-Chip enthält eine Vielzahl von Ein- und/oder Ausgabeanschlüssen P1 bis Pn, I/O-Interfaces IOI1 bis IOI4, eine Testsignalerzeugungseinrichtung TGEN, und eine im folgenden als Testsignal-Leitung bezeichnete Leitung TL.

Die Ein- und/oder Ausgabeanschlüsse P1 bis Pn sind beispielsweise die sogenannten Pads des Halbleiter-Chips.

Die I/O-Interfaces IOI1 bis IOI4 sind jeweils bestimmten Ein- und/oder Ausgabeanschlüssen zugeordnete Einrichtungen. Sie sind mit den ihnen zugeordneten Ein- und/oder Ausgabeanschlüssen verbunden und sorgen dafür, daß die über die zugeordneten Ein- und/oder Ausgabeanschlüsse auszugebenden Daten ordnungsgemäß ausgegeben werden, und daß die den zugeordneten Ein- und/oder Ausgabeanschlüssen von außerhalb des Halbleiter-Chips zugeführten Daten ordnungsgemäß empfangen werden.

Üblicherweise ist fast jedem der Ein- und/oder Ausgabeanschlüsse P1 bis Pn ein I/O-Interface vorgeschaltet. Dies ist auch im betrachteten Beispiel so. In der Figur sind jedoch der Übersichtlichkeit halber nicht alle I/O-Interfaces dargestellt.

Im betrachteten Beispiel sind das I/O-Interface IOI1 mit nur einem Ein- und/oder Ausgabeanschluß verbunden, das I/O-Interface IOI2 mit zwei Ein- und/oder Ausgabeanschlüssen verbunden, das I/O-Interface IOI3 mit vier Ein- und/oder Ausgabeanschlüssen verbunden, und das I/O-Interface IOI4 mit fünf Ein- und/oder Ausgabeanschlüssen verbunden. Der Vollständigkeit halber sei angemerkt, daß die I/O-Interfaces IOI1 bis IOI4 unabhängig voneinander mit beliebig vielen Ein- und/oder Ausgabeanschlüssen verbunden sein können, und daß der Halbleiter-Chip auch beliebig viel mehr oder weniger als vier I/O-Interfaces enthalten kann.

Die I/O-Interfaces IOI1 bis IOI4 enthalten für jeden der ihnen zugeordneten Ein- und/oder Ausgabeanschlüsse, über welchen aus dem Halbleiter-Chip Daten ausgebbar sein sollen, einen in der Figur 1 nicht gezeigten Ausgangstreiber. Die Ausgangsanschlüsse der Ausgangstreiber sind mit den zugeordneten Ein- und/oder Ausgabeanschlüssen verbunden. Im betrachteten Beispiel werden die Ausgangstreiber durch Tristate-Treiber gebildet. Die Ausgangstreiber könnten aber auch beliebige andere Treiber sein.

Die I/O-Interfaces IOI1 bis IOI4 steuern die Ausgangstreiber so an,
- daß an ihren Eingangsanschluß eine erste Spannung angelegt wird, wenn aus dem zugeordneten Ein- und/oder Ausgabeanschluß ein Signal mit hohem Pegel ausgegeben werden soll,
- daß an ihren Eingangsanschluß eine zweite Spannung angelegt wird, wenn aus dem zugeordneten Ein- und/oder Ausgabeanschluß ein Signal mit niedrigem Pegel ausgegeben werden soll, und
- daß an ihren Eingangsanschluß keine Spannung angelegt wird, wenn aus dem zugeordneten Ein- und/oder Ausgabeanschluß kein Signal ausgegeben werden soll, oder über den betreffenden Ein- und/oder Ausgabeanschluß Daten empfangen werden sollen.

Die I/O-Interfaces IOI1 bis IOI4 werden ihrerseits durch die CPU oder eine sonstige Komponente des Halbleiter-Chips gesteuert. Genauer gesagt wird den I/O-Interfaces IOI1 bis IOI4 von der CPU oder einer sonstigen Komponente des Halbleiter-Chips vorgegeben, wie die Ein- und/oder Ausgabeanschlüsse P1 bis Pn zu verwenden sind, und welche Daten über die Ein- und/oder Ausgabeanschlüsse P1 bis Pn auszugeben sind.

Die Steuerung der I/O-Interfaces IOI1 bis IOI4 kann beispielsweise über Steuerleitungen IOC1 bis IOC8 erfolgen, wobei jedes I/O-Interface mit einer oder mehreren ersten Steuerleitungen IOC1, IOC3, IOC5, und IOC7, und einer oder mehreren zweiten Steuerleitungen IOC2, IOC4, IOC6, und IOC8 verbunden ist, und wobei den I/O-Interfaces IOI1 bis IOI4 durch die ersten Steuerleitungen IOC1, IOC3, IOC5, und IOC7 vorgegeben wird, ob die ihnen zugeordneten Ein- und/oder Ausgabeanschlüsse P1 bis Pn des Halbleiter-Chips als Eingangsanschlüsse oder als Ausgangsanschlüsse konfiguriert werden sollen, und wobei den I/O-Interfaces IOI1 bis IOI4 durch die zweiten Steuerleitungen IOC2, IOC4, IOC6, und IOC8 vorgegeben wird, welche Daten über die ihnen zugeordneten Ein- und/oder Ausgabeanschlüsse P1 bis Pn des Halbleiter-Chips ausgegeben werden sollen, falls die zugeordneten Ein- und/oder Ausgabeanschlüsse als Ausgabeanschlüsse verwendet werden sollen.

Die Ansteuerung der I/O-Interfaces kann selbstverständlich auch auf beliebige andere Art und Weise erfolgen.

Die I/O-Interfaces IOI1 bis IOI4 enthalten darüber hinaus jeweils eine Testsignalauswertungseinrichtung TCHK, welche mit der vorstehend bereits erwähnten Testsignal-Leitung TL verbunden ist. Diese Testsignalauswertungseinrichtungen TCHK werden später noch genauer beschrieben.

Über die Testsignal-Leitung TL wird ein Testsignal übertragen. Dieses Testsignal wird von der vorstehend bereits erwähnten Testsignalerzeugungseinrichtung TGEN erzeugt und auf die Testsignal-Leitung TL ausgegeben.

Der Verlauf der Testsignal-Leitung TL ist so gewählt, daß die Testsignal-Leitung bei einer mechanischen Beschädigung des Halbleiter-Chips mitbeschädigt wird. Die Testsignal-Leitung TL soll zumindest durch einen Bruch des Halbleiter-Chips und/oder durch einen im Halbleiter-Chip auftretenden Riß und/oder durch Verformungen des Halbleiter-Chips stark beschädigt, vorzugsweise ganz durchtrennt werden.

Im betrachteten Beispiel beginnt die Testsignal-Leitung TL an der Testsignalerzeugungseinrichtung TGEN, verläuft dann entlang des äußeren Randes des Halbleiter-Chips um diesen herum, und endet an den Testsignalauswertungseinrichtungen TCHK der I/O-Interfaces IOI1 bis IOI4.

Dies ist jedoch nicht die einzige Möglichkeit zur Führung der Testsignal-Leitung TL. Die Testsignal-Leitung TL könnte beispielsweise auch mäanderförmig über die gesamte Halbleiter-Chip-Fläche geführt werden, oder so geführt werden, daß sie einzelne, mehrere, oder alle Schaltungskomponenten wie beispielsweise die CPU und/oder den Speicher und/oder die einzelnen Peripherieeinheiten einzeln umläuft oder nahe daran vorbeiläuft.

Ein geeigneter Verlauf der Testsignal-Leitung TL ermöglicht es im Zusammenwirken mit dem darüber übertragenen Testsignal, mechanische Beschädigungen des Halbleiter-Chips, zu erkennen und entsprechend darauf zu reagieren.

Eine Beschädigung der Testsignal-Leitung TL, beispielsweise eine Durchtrennung der Testsignal-Leitung TL hat nämlich unweigerlich zur Folge, daß die Übertragung des Testsignals zu den Testsignalauswertungseinrichtungen TCHK der I/O-Interfaces IOI1 bis IOI4 unterbrochen oder gestört wird, und dies läßt sich relativ einfach erkennen.

Im betrachteten Beispiel wird durch die Testsignalauswertungseinrichtungen TCHK fortlaufend überwacht, ob das ihnen über die Testsignal-Leitung TL zugeführte Signal das Testsignal ist, das von der Testsignalerzeugungseinrichtung TGEN auf die Testsignal-Leitung TL ausgegeben wird.

Wenn bei dieser Überprüfung festgestellt wird, daß das den Testsignalauswertungseinrichtungen TCHK über die Testsignal-Leitung TL zugeführte Signal nicht mit dem von der Testsignalerzeugungseinrichtung TGEN erzeugten Testsignal übereinstimmt, oder daß das den Testsignalauswertungseinrichtungen TCHK über die Testsignal-Leitung TL zugeführte Signal ungewöhnlich stark verzerrt ist, wird davon ausgegangen, daß eine Beschädigung der Testsignal-Leitung TL und mithin auch eine Beschädigung des Halbleiter-Chips vorhanden ist.

Anderenfalls, d.h. wenn das den Testsignalauswertungseinrichtungen TCHK über die Testsignal-Leitung TL zugeführte Signal mit dem von der Testsignalerzeugungseinrichtung TGEN erzeugten Testsignal übereinstimmt, wird davon ausgegangen, daß keine Beschädigung des Halbleiter-Chips vorhanden ist.

Wenn aufgrund der in den Testsignalauswertungseinrichtungen TCHK durchgeführten Überprüfungen davon auszugehen ist, daß eine Beschädigung des Halbleiter-Chips aufgetreten ist, veranlassen Testsignalauswertungseinrichtungen TCHK, daß der Halbleiter-Chip oder bestimmte Teile desselben in einen definierten Zustand versetzt werden.

Im betrachteten Beispiel ist es so, daß die Testsignalauswertungseinrichtungen TCHK jeweils die sie enthaltenden Halbleiter-Chip-Komponenten, also die I/O-Interfaces IOI1 bis IOI4 bzw. die diesen zugeordneten Ein- und/oder Ausgabeanschlüsse P1 bis Pn in einen definierten Zustand versetzen.

Die Testsignalauswertungseinrichtungen TCHK können zusätzlich zu den I/O-Interfaces IOI1 bis IOI4, oder anstelle der I/O-Interfaces IOI1 bis IOI4 auch beliebige andere Halbleiter-Chip-Komponenten in einen definierten Zustand versetzen. Es erweist sich jedoch als vorteilhaft, wenn die Testsignalauswertungseinrichtung, die eine bestimmte Halbleiter-Chip-Komponente in einen definierten Zustand versetzt, Bestandteil der betreffenden Halbleiter-Chip-Komponente ist, oder in unmittelbarer Nähe dieser Halbleiter-Chip-Komponente angeordnet ist.

Der Vollständigkeit halber sei angemerkt,
- daß der Halbleiter-Chip beliebig viele Testsignalauswertüngseinrichtungen TCHK aufweisen kann,
- daß die Testsignalauswertungseinrichtungen TCHK Bestandteil beliebiger Halbleiter-Chip-Komponenten sein können, und
- daß die Testsignalauswertungseinrichtungen TCHK auch durch eigenständige Halbleiter-Chip-Module gebildet werden können, also nicht Bestandteil einer bestimmten Halbleiter-Chip-Komponente wie zum Beispiel eines I/O-Interfaces, der CPU, oder des Speichers sein müssen.

Wie vorstehend bereits erwähnt wurde, ist es im betrachteten Beispiel so, daß die Testsignalauswertungseinrichtungen TCHK Bestandteil der I/O-Interfaces IOI1 bis IOI4 sind und beim Erkennen einer Beschädigung des Halbleiter-Chips die sie enthaltenden I/O-Interfaces in einen definierten Zustand versetzen.

Der definierte Zustand besteht im betrachteten Beispiel darin, daß die in den I/O-Interfaces IOI1 bis IOI4 enthaltenen Ausgangstreiber in einen Zustand versetzt werden, in welchem sie keine Daten ausgeben, und - von außerhalb des Halbleiter-Chips gesehen - hochohmig sind. Dies läßt sich im betrachteten Beispiel dadurch erreichen, daß den Eingangsanschlüssen der Ausgangstreiber keine Spannung, d.h. weder eine hohe Spannung, noch eine niedrige Spannung noch eine sonstige Spannung zugeführt wird.

Dies kann beispielsweise dadurch bewerkstelligt werden, daß die I/O-Interfaces nicht in alleiniger Abhängigkeit von den über die ersten Steuerleitungen IOC1, IOC3, IOC5, und IOC7 und den über die zweiten Steuerleitungen IOC2, IOC4, IOC6, und IOC8 erhaltenen Steuersignalen arbeiten, sondern unter zusätzlicher Berücksichtigung von einem oder mehreren weiteren Steuersignalen, die jede der Testsignalauswertungseinrichtungen TCHK erzeugt. Die Testsignalauswertungseinrichtungen TCHK erzeugen im betrachteten Beispiel ein Steuersignal, durch welches signalisiert wird, ob eine Beschädigung des Halbleiter-Chips erkannt wurde. Dieses Steuersignal wird innerhalb der I/O-Interfaces so verarbeitet, daß diese dadurch in den vorstehend beschriebenen definierten Zustand versetzt werden. Die Verarbeitung des von den Testsignalauswertungseinrichtungen TCHK erzeugten Steuersignals kann beispielsweise durch eine logische Verknüpfung dieses Steuersignals mit den über die ersten Steuerleitungen IOC1, IOC3, IOC5, und IOC7 übertragenen Signalen, und die Verwendung des aus der Verknüpfung resultierenden Signals zur Steuerung der I/O-Interfaces erfolgen.

Es dürfte einleuchten und bedarf keiner näheren Erläuterung, daß dies nicht die einzige Möglichkeit ist, um die I/O-Interfaces in den gewünschten Zustand zu versetzen. Hierfür existieren diverse weitere Möglichkeiten.

Ebenso dürfte einleuchten, daß die I/O-Interfaces nach der Erkennung einer Beschädigung des Halbleiter-Chips auch in einen anderen definierten Zustand als den vorstehend beschriebenen Zustand versetzt werden können. Beispielsweise können die I/O-Interfaces nach der Erkennung einer Beschädigung des Halbleiter-Chips in einen Zustand versetzt werden,
- in welchem aus einzelnen, mehreren, oder allen Ein- und/oder Ausgabeanschlüssen ein einen hohen Pegel repräsentierendes Signal ausgegeben wird, und/oder
- in welchem aus einzelnen, mehreren, oder allen Ein- und/oder Ausgabeanschlüssen ein einen niedrigen Pegel repräsentierendes Signal ausgegeben wird, und/oder
- in welchem aus einzelnen, mehreren oder allen Ein- und/oder Ausgabeanschlüssen vorgegebene Signalfolgen ausgegeben werden.

Beim vorstehend beschriebenen Beispiel sind alle Testsignalauswertungseinrichtungen TCHK mit ein- und derselben Testsignal-Leitung TL verbunden. Dies muß jedoch nicht so sein. Die mehreren Testsignalauswertungseinrichtungen TCHK können auch mit verschiedenen Testsignal-Leitungen TL verbunden sein.

Beim vorstehend beschriebenen Beispiel ist jede Testsignalauswertungseinrichtung TCHK mit genau einer Testsignal-Leitung TL verbunden. Auch dies muß nicht so sein. Einzelne, mehrere, oder alle Testsignalauswertungseinrichtungen TCHK können auch jeweils mit mehreren Testsignal-Leitungen TL verbunden sein und die hierüber übertragenen Testsignale gleichzeitig oder abwechselnd auswerten.

Wenn mehrere Testsignal-Leitungen vorgesehen sind, können diese unabhängig voneinander einen beliebigen Verlauf haben. Ferner können über die mehreren Testsignal-Leitungen die gleichen oder unterschiedliche Testsignale übertragen werden.

Wie vorstehend bereits erwähnt wurde, wird das über die Testsignal-Leitung TL übertragene Testsignal durch die Testsignalerzeugungseinrichtung TGEN erzeugt und auf die Testsignal-Leitung TL ausgegeben.

Das Testsignal besteht im einfachsten Fall aus der positiven Versorgungsspannung (VDD) oder der negativen Versorgungsspannung (VSS) des Halbleiter-Chips.

Sicherer funktioniert die Erkennung von Halbleiter-Chip-Beschädigungen allerdings, wenn als Testsignal eine zwischen der positiven Versorgungsspannung und der negativen Versorgungsspannung liegende Gleichspannung, beispielsweise VDD/2 verwendet wird.

Noch sicherer funktioniert die Erkennung von Halbleiter-Chip-Beschädigungen, wenn als Testsignal eine Gleichspannung verwendet wird, die größer ist als die positive Versorgungsspannung (VDD) des Halbleiter-Chips oder kleiner ist als die negative Versorgungsspannung (VSS) des Halbleiter-Chips.

Genau so sicher oder sogar noch sicherer funktioniert die Erkennung von Halbleiter-Chip-Beschädigungen, wenn als Testsignal eine periodische Signalfolge verwendet wird.

Bei der Verwendung einer periodischen Signalfolge als Testsignal wird vorzugsweise eine Signalfolge verwendet, die im Halbleiter-Chip nicht oder allenfalls zufällig nochmals vorkommt, also beispielsweise keine Signalfolge, die dem Taktsignal entspricht, mit welchem der Halbleiter-Chip arbeitet. Besonders sicher funktioniert die Erkennung von Halbleiter-Chip-Beschädigungen, wenn die Spannungen, zwischen welchen die Signalfolge hin- und herspringt, nicht die positive Versorgungsspannung (VDD) und/oder nicht die negative Versorgungsspannung (VSS) des Halbleiter-Chips umfaßt.

Es erweist sich als vorteilhaft, wenn die Testsignal-Leitung TL über Pull-Up-Widerstände oder Pull-Down-Widerstände mit einem Knoten verbunden ist, der mit einer mit dem Testsignal nicht übereinstimmenden Spannung oder Signalfolge beaufschlagt ist. Dann kann nämlich nicht nur ermittelt werden, ob eine Halbleiter-Chip-Beschädigung aufgetreten ist, sondern auch wo diese Beschädigung aufgetreten ist.

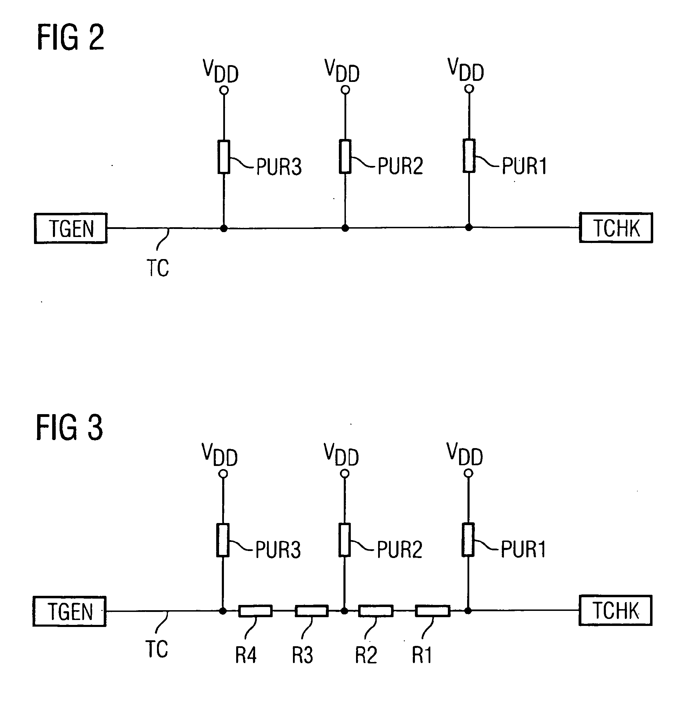

Dies wird im folgenden unter Bezugnahme auf die Figur 2 anhand eines Beispiels näher erläutert.

Die Figur 2 zeigt die Testsignal-Leitung TL, die Testsignalerzeugungseinrichtung TGEN, die Testsignalauswertungseinrichtung TCHK, und Pull-Up-Widerstände PUR1 bis PUR3, über welche die Testsignal-Leitung TL mit einem hohen Potential, beispielsweise mit VDD verbunden ist.

Die Pull-Up-Widerstände PUR1 bis PUR3 beeinflussen die Übertragung des Testsignals über die Testsignal-Leitung TL nicht oder allenfalls in vernachlässigbarem Umfang. Sie ermöglichen es aber, die Stelle zu ermitteln, an welcher die Testsignal-Leitung im Fall einer mechanischen Beschädigung des Halbleiter-Chips unterbrochen ist.

Dies läßt sich anhand eines Beispiels veranschaulichen:

Es sei zunächst angenommen, daß die Testsignal-Leitung TL keine Unterbrechung aufweist. In diesem Fall wird der Testsignalauswertungseinrichtung TCHK über die Testsignal-Leitung TL das von der Testsignalerzeugungseinrichtung erzeugte Testsignal zugeführt, und die Testsignalauswertungseinrichtung TCHK erkennt hieran, daß keine mechanische Beschädigung des Halbleiter-Chips vorliegt.

Wenn die Testsignal-Leitung TL zwischen der Testsignalerzeugungseinrichtung TGEN und dem Pull-Up-Widerstand, der der Testsignalauswertungseinrichtung TCHK am nächsten liegt, also dem Pull-Up-Widerstand PUR1 unterbrochen ist, wird der Testsignalauswertungseinrichtung TCHK über die Testsignal-Leitung TL anstelle des Testsignals die Spannung zugeführt, über welche die Testsignal-Leitung TL über die Pull-Up-Widerstände PUR1 bis PUR3 verbunden ist. Hieran erkennt die Testsignalauswertungseinrichtung TCHK, daß eine mechanische Beschädigung des Halbleiter-Chips vorliegt, und daß die Testsignal-Leitung TL nicht in unmittelbarer Nähe zur Testsignalauswertungseinrichtung TCHK, genauer gesagt nicht zwischen der Testsignalauswertungseinrichtung TCHK und dem Pull-Up-Widerstand PUR1 unterbrochen ist.

Wenn die Testsignal-Leitung TL zwischen Testsignalauswertungseinrichtung TCHK und dem Pull-Up-Widerstand, der der Testsignalauswertungseinrichtung TCHK am nächsten liegt, also dem Pull-Up-Widerstand PUR1 unterbrochen ist, wird der Testsignalauswertungseinrichtung TCHK über die Testsignal-Leitung weder das Testsignal noch die Spannung zugeführt, über welche die Testsignal-Leitung TL über die Pull-Up-Widerstände PUR1 bis PUR3 verbunden ist. Hieran erkennt die Testsignalauswertungseinrichtung TCHK, daß eine mechanische Beschädigung des Halbleiter-Chips vorliegt, und daß die Testsignal-Leitung TL zwischen der Testsignalauswertungseinrichtung TCHK und dem Pull-Up-Widerstand PUR1 unterbrochen ist.

Wenn die Testsignalauswertungseinrichtung TCHK festgestellt hat, daß die Testsignal-Leitung TL zwischen der Testsignalerzeugungseinrichtung TGEN und dem Pull-Up-Widerstand PUR1 unterbrochen ist, kann sie durch weitere Überprüfungen feststellen, ob sich die Unterbrechung zwischen den Pull-Up-Widerständen PUR1 und PUR2 befindet, oder sich zwischen den Pull-Up-Widerständen PUR2 und PUR3 befindet, oder sich zwischen dem Pull-Up-Widerstand PUR3 und der Testsignalerzeugungseinrichtung TGEN befindet. Hierzu verbindet die Testsignalauswertungseinrichtung TCHK mit Masse oder einer sonstigen von VDD verschiedenen Spannung und ermittelt den Strom, der dann über die Testsignal-Leitung TL fließt.

Die Größe des Stromes hängt von der Stelle ab, an welcher die Testsignal-Leitung TL unterbrochen ist. Der über die Testsignal-Leitung TS fließende Strom
- ist am kleinsten, wenn die Unterbrechung der Testsignal-Leitung TL zwischen den Pull-Up-Widerständen PUR1 und PUR2 liegt,
- ist größer, wenn die Unterbrechung der Testsignal-Leitung TL zwischen den Pull-Up-Widerständen PUR2 und PUR3 liegt, und
- ist am größten, wenn die Unterbrechung der Testsignal-Leitung TL zwischen dem Pull-Up-Widerstand PUR3 und der Testsignalerzeugungseinrichtung TGEN liegt.

Die Testsignalauswertungseinrichtung TCHK kann somit aus der Größe des über die Testsignal-Leitung TL fließenden Stromes die Stelle ermitteln, an welcher die Testsignal-Leitung unterbrochen ist. Dies geschieht im betrachteten Beispiel durch einen Vergleich des ermittelten Stromes mit in der Testsignalauswertungseinrichtung TCHK gespeicherten Strömen.

Entsprechendes gilt, wenn die Testsignal-Leitung TC über Pull-Down-Widerstände mit dem niedrigeren Versorgungspotential VSS des Halbleiter-Chips verbunden ist.

Es kann sich als vorteilhaft erweisen, wenn das Potential, mit welchem die Testsignal-Leitung TC über die Pull-Up-Widerstände oder die Pull-Down-Widerstände verbunden ist, ein Potential ist, daß kleiner ist als VSS, oder größer ist als VDD, oder zwischen VSS und VDD liegt. Dadurch könnte an der über die Testsignal-Leitung TC übertragenen Spannung erkannt werden, wenn die Testsignal-Leitung TC durch die Beschädigung des Halbleiter-Chips mit einer anderen Leitung des Halbleiter-Chips in Kontakt gekommen ist, und somit keine Bestimmung der Stelle möglich ist, an welcher die Testsignal-Leitung TC unterbrochen ist. Der selbe positive Effekt läßt sich erzielen, wenn die Testsignal-Leitung TC über die Pull-Up-Widerstände oder die Pull-Down-Widerstände mit einem Signalgenerator verbunden ist, der eine periodische Signalfolge ausgibt, wobei diese Signalfolge jedoch nicht der von der Testsignalerzeugungseinrichtung erzeugten Signalfolge entsprechen darf.

Eine noch genauere Ermittlung der Stelle, an welcher die Testsignal-Leitung TL unterbrochen ist, ist möglich, wenn längs der Testsignal-Leitung TL Widerstände R eingebaut werden.

Ein Beispiel hierfür ist in Figur 3 veranschaulicht. Die in der Figur 3 gezeigte Anordnung basiert auf der in der Figur 2 gezeigten Anordnung. Mit den gleichen Bezugszeichen bezeichnete Komponenten sind identische oder einander entsprechende Komponenten. Bei der in der Figur 3 gezeigten Anordnung enthält die Testsignal-Leitung TL jedoch zusätzlich zwischen den Pull-Up-Widerständen PUR1 und PUR2 in Reihe geschaltete Widerstände R1 und R2, und zwischen den Pull-Up-Widerständen PUR2 und PUR3 in Reihe geschaltete Widerstände R3 und R4.

Bei einer solchen Ausbildung der Testsignal-Leitung TL hängt die Größe des Stromes, der über die Testsignal-Leitung fließt, zusätzlich davon ab, ob die Unterbrechung der Testsignal-Leitung zwischen dem Pull-Up-Widerstand PUR1 und dem Widerstand R1 liegt, oder zwischen den Widerständen R1 und R2, oder zwischen dem Widerstand R2 und dem Pull-Up-Widerstand PUR2, oder zwischen dem Pull-Up-Widerstand PUR2 und dem Widerstand R3, oder zwischen den Widerständen R3 und R4, oder zwischen dem Widerstand R4 und dem Pull-Up-Widerstand PUR3.

Durch eine solche Ausbildung der Testsignal-Leitung TL läßt sich die Stelle, an welcher die Testsignal-Leitung TL unterbrochen ist, noch genauer ermitteln als es durch die Testsignal-Leitung gemäß Figur 2 der Fall ist.

Von der ermittelten Stelle der Unterbrechung der Testsignal-Leitung TL kann es abhängig gemacht werden, wie auf diese Unterbrechung, genauer gesagt auf die Halbleiter-Chip-Beschädigung, die diese Unterbrechung verursacht hat, reagiert wird. Beispielsweise könnte vorgesehen werden, nur diejenigen Halbleiter-Chip-Komponenten in einen definierten Zustand zu versetzen, die in der Nähe der Halbleiter-Chip-Beschädigung angeordnet sind. Somit ist es möglich, bestimmte Teile des Halbleiter-Chips unverändert oder zumindest eingeschränkt weiterlaufen zu lassen.

Der beschriebene Halbleiter-Chip ermöglicht es unabhängig von den Einzelheiten der praktischen Realisierung, den Aufwand zu reduzieren, der erforderlich ist, um ein Halbleiter-Chips enthaltendes System zu realisieren, das unter keinen Umständen fehlerhaft arbeiten darf.

## Patentansprüche

1. Halbleiter-Chip, mit einer Überwachungseinrichtung (TGEN, TL, TCHK), durch welche überwachbar ist, ob der Halbleiter-Chip mechanisch beschädigt ist,
**dadurch gekennzeichnet,**
**daß** die Überwachungseinrichtung (TGEN, TL, TCHK) eine Testsignal-Leitung (TL) umfaßt, über welche ein Testsignal übertragen wird, und
**daß** die Überwachungseinrichtung (TGEN, TL, TCHK) mindestens eine Testsignalauswertungseinrichtung (TCHK) enthält, wobei die mindestens eine Testsignalauswertungseinrichtung (TCHK) mit der Testsignal-Leitung (TL) verbunden ist und überprüft, ob ihr über die Testsignal-Leitung (TL) das Testsignal zugeführt wird.

2. Halbleiter-Chip nach Anspruch 1,
**dadurch gekennzeichnet,**
**daß** die Testsignal-Leitung (TL) den Halbleiter-Chip entlang des äußeren Randes desselben umläuft.

3. Halbleiter-Chip nach Anspruch 1,
**dadurch gekennzeichnet,**
**daß** die Testsignal-Leitung (TL) eine, mehrere, oder alle Komponenten der durch den elektrischen Halbleiter-Chip realisierten elektrischen Schaltung einzeln umläuft oder in unmittelbarer Nähe derselben vorbeiläuft.

4. Halbleiter-Chip nach Anspruch 1,
**dadurch gekennzeichnet,**
**daß** die Testsignal-Leitung (TL) mäanderförmig über den Halbleiter-Chip verläuft.

5. Halbleiter-Chip nach Anspruch 1,
**dadurch gekennzeichnet,**
**daß** die mindestens eine Testsignalauswertungseinrichtung (TCHK) davon ausgeht, daß der Halbleiter-Chip mechanisch beschädigt ist, wenn ihr über die Testsignal-Leitung (TL) nicht das Testsignal zugeführt wird.

6. Halbleiter-Chip nach Anspruch 1,
**dadurch gekennzeichnet,**
**daß** die mindestens eine Testsignalauswertungseinrichtung (TCHK) dann, wenn ihr über die Testsignal-Leitung (TL) nicht das Testsignal zugeführt wird, eine, mehrere, oder alle Komponenten der durch den Halbleiter-Chip realisierten elektrischen Schaltung in einen definierten Zustand versetzt.

7. Halbleiter-Chip nach Anspruch 1,
**dadurch gekennzeichnet,**
**daß** die mindestens eine Testsignalauswertungseinrichtung (TCHK) Bestandteil der Komponente der elektrischen Schaltung ist, welche sie in einen definierten Zustand versetzt.

8. Halbleiter-Chip nach Anspruch 1,
**dadurch gekennzeichnet,**
**daß** die mindestens eine Testsignalauswertungseinrichtung (TCHK) ein I/O-Interface (IOI1-IOI4) der durch den Halbleiter-Chip realisierten elektrischen Schaltung in einen definierten Zustand versetzt.

9. Halbleiter-Chip nach Anspruch 8,
**dadurch gekennzeichnet,**
**daß** die mindestens eine Testsignalauswertungseinrichtung (TCHK) das I/O-Interface (IOI1-IOI4) so ansteuert, daß dieses dafür sorgt, daß aus den dem I/O-Interface zugeordneten Ein- und/oder Ausgabeanschlüssen des Halbleiter-Chips keine Daten oder durch die mindestens eine Testsignalauswertungseinrichtung (TCHK) festgelegte Daten ausgegeben werden.

10. Halbleiter-Chip nach Anspruch 1,
**dadurch gekennzeichnet,**
**daß** das Testsignal eines der Versorgungsspannungspotentiale des Halbleiter-Chips ist.

11. Halbleiter-Chip nach Anspruch 1,
**dadurch gekennzeichnet,**
**daß** das Testsignal eine sich von den Versorgungsspannungspotentialen des Halbleiter-Chips unterscheidende Gleichspannung ist.

12. Halbleiter-Chip nach Anspruch 1,
**dadurch gekennzeichnet,**
**daß** das Testsignal eine zwischen zwei Potentialen hin- und herspringende Signalfolge ist.

13. Halbleiter-Chip nach Anspruch 12,
**dadurch gekennzeichnet,**
**daß** die Signalfolge eine sich periodisch wiederholende Signalfolge ist.

14. Halbleiter-Chip nach Anspruch 12,
**dadurch gekennzeichnet,**
**daß** die Signalfolge eine Signalfolge ist, die nicht einem Taktsignal entspricht, mit welchem der Halbleiter-Chip oder eine bestimmte Komponente desselben arbeitet.

15. Halbleiter-Chip nach Anspruch 12,
**dadurch gekennzeichnet,**
**daß** die Potentiale, zwischen welchen das Testsignal hin- und herspringt, nicht das höhere und/oder das niedrigere Potential der Versorgungsspannung des Halbleiter-Chips umfassen.

16. Halbleiter-Chip nach Anspruch 1,
**dadurch gekennzeichnet,**
**daß** die Testsignal-Leitung (TL) über einen oder mehrere Pull-Up-Widerstände oder Pull-Down-Widerstände (PUR1-PUR3) mit einem Knoten verbunden ist, der mit einer mit dem Testsignal nicht übereinstimmenden Spannung oder Signalfolge beaufschlagt ist.

17. Halbleiter-Chip nach Anspruch 16,
**dadurch gekennzeichnet,**
**daß** die Testsignal-Leitung (TL) einen oder mehrere in Reihe geschaltete Widerstände (R1-R4) enthält.

18. Halbleiter-Chip nach Anspruch 16,
**dadurch gekennzeichnet,**
**daß** die mindestens eine Testsignalauswertungseinrichtung (TCHK) dann, wenn ihr über die Testsignal-Leitung (TL) die am Knoten anliegende Spannung oder Signalfolge zugeführt wird, die Testsignal-Leitung (TL) kurzschließt und die Größe des Stromes ermittelt, der dann über die Testsignal-Leitung (TL) fließt.

19. Halbleiter-Chip nach Anspruch 18,
**dadurch gekennzeichnet,**
**daß** die Reaktion der mindestens einen Testsignalauswertungseinrichtung (TCHK) auf das Erkennen einer Unterbrechung der Testsignal-Leitung (TL) von der Größe des ermittelten Stromes abhängt.

## Claims

1. Semiconductor chip, comprising a monitoring device (TGEN, TL, TCHK), which can be used to monitor whether the semiconductor chip is mechanically damaged,
**characterized**
**in that** the monitoring device (TGEN, TL, TCHK) comprises a test signal line (TL), via which a test signal is transmitted and
**in that** the monitoring device (TGEN, TL, TCHK) contains at least one test signal evaluation device (TCHK), the at least one test signal evaluation device (TCHK) being connected to the test signal line (TL) and checking whether the test signal is fed to it via the test signal line (TL).

2. Semiconductor chip according to Claim 1,
**characterized**
**in that** the test signal line (TL) runs around the semiconductor chip along the outer edge thereof.

3. Semiconductor chip according to Claim 1,
**characterized**
**in that** the test signal line (TL) individually runs around one, a plurality, or all of the components of the electrical circuit realized by the electrical semiconductor chip or runs past in direct proximity thereto.

4. Semiconductor chip according to Claim 1,
**characterized**
**in that** the test signal line (TL) runs in meandering fashion over the semiconductor chip.

5. Semiconductor chip according to Claim 1,
**characterized**
**in that** the at least one test signal evaluation device (TCHK) assumes that the semiconductor chip is mechanically damaged if the test signal is not fed to it via the test signal line (TL).

6. Semiconductor chip according to Claim 1,
**characterized**
**in that** the at least one test signal evaluation device (TCHK), when the test signal is not fed to it via the test signal line (TL), puts one, a plurality, or all of the components of the electrical circuit realized by the semiconductor chip into a defined state.

7. Semiconductor chip according to Claim 1,
**characterized**
**in that** the at least one test signal evaluation device (TCHK) is a constituent part of the component of the electrical circuit which it puts into a defined state.

8. Semiconductor chip according to Claim 1,
**characterized**
**in that** the at least one test signal evaluation device (TCHK) puts an I/O interface (IOI1-IOI4) of the electrical circuit realized by the semiconductor chip into a defined state.

9. Semiconductor chip according to Claim 8,
**characterized**
**in that** the at least one test signal evaluation device (TCHK) drives the I/O interface (IOI1-IOI4) in such a way that the latter ensures that no data or data defined by the at least one test signal evaluation device (TCHK) are output from the input and/or output terminals of the semiconductor chip which are assigned to the I/O interface.

10. Semiconductor chip according to Claim 1,
**characterized**
**in that** the test signal is one of the supply voltage potentials of the semiconductor chip.

11. Semiconductor chip according to Claim 1,
**characterized**
**in that** the test signal is a DC voltage that differs from the supply voltage potentials of the semiconductor chip.

12. Semiconductor chip according to Claim 1,
**characterized**
**in that** the test signal is a signal sequence jumping back and forth between two potentials.

13. Semiconductor chip according to Claim 12,
**characterized**
**in that** the signal sequence is a periodically recurring signal sequence.

14. Semiconductor chip according to Claim 12,
**characterized**
**in that** the signal sequence is a signal sequence which does not correspond to a clock signal with which the semiconductor chip or a specific component thereof operates.

15. Semiconductor chip according to Claim 12,
**characterized**
**in that** the potentials between which the test signal jumps back and forth do not comprise the higher and/or the lower potential of the supply voltage of the semiconductor chip.

16. Semiconductor chip according to Claim 1,
**characterized**
**in that** the test signal line (TL) is connected via one or a plurality of pull-up resistors or pull-down resistors (PUR1-PUR3) to a node to which a voltage or signal sequence not corresponding to the test signal is applied.

17. Semiconductor chip according to Claim 16,
**characterized**
**in that** the test signal line (TL) contains one or a plurality of series-connected resistors (R1-R4).

18. Semiconductor chip according to Claim 16,
**characterized**
**in that** the at least one test signal evaluation device (TCHK), when the voltage or signal sequence present at the node is fed to it via the test signal line (TL), short-circuits the test signal line (TL) and determines the magnitude of the current which then flows via the test signal line (TL).

19. Semiconductor chip according to Claim 18,
**characterized**
**in that** the reaction of the at least one test signal evaluation device (TCHK) to the identification of an interruption of the test signal line (TL) depends on the magnitude of the current determined.

## Revendications

1. Puce semi-conductrice qui présente un dispositif de surveillance (TGEN, TL, TCHK) qui permet de surveiller si la puce semi-conductrice a été endommagée mécaniquement,
**caractérisée en ce que**
le dispositif de surveillance (TGEN, TL, TCHK) comprend un conducteur (TL) de signaux de test par lequel un signal de test est transmis et
**en ce que** l'unité de surveillance (TGEN, TL, TCHK) contient au moins un dispositif (TCHK) d'évaluation du signal de test, le ou les dispositifs (TCHK) d'évaluation du signal de test étant reliés au conducteur (TL) de signaux de test et vérifiant si le signal de test lui a été envoyé par le conducteur (TL) de signaux de test.

2. Puce semi-conductrice selon la revendication 1, **caractérisée en ce que** le conducteur (TL) de signaux de test entoure la puce semi-conductrice par son bord extérieur.

3. Puce semi-conductrice selon la revendication 1, **caractérisée en ce que** le conducteur (TL) de signaux de test entoure un, plusieurs ou tous les composants du circuit électrique constitué par la puce semi-conductrice ou s'étend à proximité immédiate de ces composants.

4. Puce semi-conductrice selon la revendication 1, **caractérisée en ce que** le conducteur (TL) de signaux de test s'étend en méandres sur la puce semi-conductrice.

5. Puce semi-conductrice selon la revendication 1, **caractérisée en ce que** le ou les dispositifs (TCHK) d'évaluation de signaux de test partent de l'hypothèse que la puce semi-conductrice a été endommagée mécaniquement lorsque le signal de test ne leur est pas amené par le conducteur (TL) de signaux de test.

6. Puce semi-conductrice selon la revendication 1, **caractérisée en ce que** le ou les dispositifs (TCHK) d'évaluation de signaux de test amènent un, plusieurs ou tous les composants du circuit électrique constitué par la puce semi-conductrice dans un état défini lorsque le signal de test ne leur est pas apporté par le conducteur (TL) de signaux de test.

7. Puce semi-conductrice selon la revendication 1, **caractérisée en ce que** le ou les dispositifs (TCHK) d'évaluation du signal de test font partie des composants du circuit électrique qui les amène dans un état défini.

8. Puce semi-conductrice selon la revendication 1, **caractérisée en ce que** le ou les dispositifs (TCHK) d'évaluation de signaux amènent dans un état défini une interface d'entrée/sortie (1011-1014) du circuit électrique constitué par la puce semi-conductrice.

9. Puce semi-conductrice selon la revendication 8, **caractérisée en ce que** le ou les dispositifs (TCHK) d'évaluation de signaux de test commandent l'interface d'entrée/sortie (IOI1-IOI4) de telle sorte que cette dernière assure que les raccordements d'entrée et/ou de sortie de la puce semi-conductrice qui sont associés à l'interface d'entrée/sortie ne délivrent pas de données ou les données définies par le ou les dispositifs (TCHK) d'évaluation de signaux de test.

10. Puce semi-conductrice selon la revendication 1, **caractérisée en ce que** le signal de test est le potentiel de la tension d'alimentation de la puce semi-conductrice.

11. Puce semi-conductrice selon la revendication 1, **caractérisée en ce que** le signal de test est une tension continue différente du potentiel de la tension d'alimentation de la puce semi-conductrice.

12. Puce semi-conductrice selon la revendication 1, **caractérisée en ce que** le signal de test est une succession de signaux qui basculent en va-et-vient entre deux potentiels.

13. Puce semi-conductrice selon la revendication 12, **caractérisée en ce que** la succession de signaux est une succession de signaux qui se répètent périodiquement.

14. Puce semi-conductrice selon la revendication 12, **caractérisée en ce que** la succession de signaux est une succession de signaux qui correspondent à un signal d'horloge auquel la puce semi-conductrice ou un composant défini de celle-ci travaille.

15. Puce semi-conductrice selon la revendication 12, **caractérisée en ce que** les potentiels entre lesquels le signal de test bascule en va-et-vient ne sont pas le potentiel supérieur ni le potentiel inférieur de la tension d'alimentation de la puce semi-conductrice.

16. Puce semi-conductrice selon la revendication 1, **caractérisée en ce que** le conducteur (TL) de signaux de test est relié par une ou plusieurs résistances de relèvement de tension ou résistances d'abaissement de tension (PUR1 - PUR3) à un noeud sur lequel une tension ou une succession de signaux qui ne correspondent pas au signal de test sont appliquées.

17. Puce semi-conductrice selon la revendication 16, **caractérisée en ce que** le conducteur (TL) de signaux de test contient une ou plusieurs résistances (R1-R4) raccordées en série.

18. Puce semi-conductrice selon la revendication 16, **caractérisée en ce que** le ou les dispositifs (TCHK) d'évaluation de signaux de test mettent en court-circuit le conducteur (TL) de signaux de test et déterminent le niveau du courant qui s'écoule alors dans le conducteur (TL) de signaux de test lorsque la tension ou la succession de signaux appliquées sur le noeud lui sont transmises par le conducteur (TL) de signaux de test.

19. Puce semi-conductrice selon la revendication 18, **caractérisée en ce que** la réaction du ou des dispositifs (TCHK) d'évaluation de signaux de test à la détection d'une interruption de conducteur (TL) de signaux de test dépend du niveau du courant déterminé.
